# EUROPEAN PATENT APPLICATION

(11) **EP 2 620 229 A1**
(43) Date of publication of application: **31.07.2013**
(21) Application number: 13151319.4
(22) Date of filing: 15.01.2013
(51) Int. Cl.: B08B 3/12

(54) **Ultrasonic cleaning method**

(30) Priority: 30.01.2012 JP 2012016722
(71) Applicant: Siltronic AG, 81737 München (DE)
(72) Inventor: Tanabe, Etsuko, Hikari, Yamaguchi 743-0031 (JP); Haibara, Teruo, Hikari, Yamaguchi 743-0011 (JP); Mori, Yoshihiro, Shunan, Yamaguchi 745-0651 (JP); Uchibe, Masashi, Hikari, Yamaguchi 743-0072 (JP)
(74) Representative: Baar, Christian

(57) **Abstract**

A cleaning method includes the steps of preparing a cleaning liquid (S10), and cleaning an object to be cleaned by dipping the object to be cleaned in the cleaning liquid while irradiating the cleaning liquid ultrasonic waves (S20). In the cleaning step (S20), the dissolved nitrogen concentration in the cleaning liquid has been adjusted in accordance with the size of a foreign substance that is to be removed from the object to be cleaned with the highest removal efficiency. In this way, a foreign substance of a specific size can be efficiently removed by changing the dissolved nitrogen concentration in the cleaning liquid in accordance with the size of the foreign substance to be removed.

## Description

### Technical Field

This invention relates to a cleaning method, and more particularly to a cleaning method for cleaning an object using a cleaning liquid irradiated with ultrasonic waves.

### Background Art

Conventionally, in a process for manufacturing a substrate such as a silicon wafer, a process for cleaning the substrate is performed, in order to remove from the substrate organic substances, metal impurities, particles (fine particles), native oxide film, and the like that may cause defects in a semiconductor device.

In the process for cleaning the substrate, any of various types of cleaning methods is used to suit its purpose. Particularly in the case of removing a foreign substance such as particles by a dip type cleaning method, a method is used in which a substrate is dipped in a cleaning liquid contained in a cleaning tank, and the cleaning liquid in which the substrate is dipped is irradiated with ultrasonic waves having a frequency around 1 MHz, referred to as "megasonics". It is generally believed that the use of ultrasonic waves having a frequency around 1 MHz can increase the cleaning effect on submicron-size microparticles on the surface of the substrate, while reducing damage to the substrate.

Here, it has been known that the dissolved gas concentration in a cleaning liquid affects the efficiency in removing a foreign substance such as particles.

For example, it has been known that in the case of removing particles from a substrate by using ultrapure water as a cleaning liquid and by irradiating the ultrapure water with megasonics, the particle removal efficiency from the substrate is affected by the dissolved nitrogen concentration in the cleaning liquid.

For example, Japanese Patent Laying-Open No. 2007-250726 discloses that particles can be removed with the highest removal efficiency when the concentration of a dissolved gas is 14 ppm or more. Japanese Patent Laying-Open No. 10-109072 discloses that when the dissolved nitrogen concentration in a cleaning liquid exceeds 10 ppm, precision cleaning of a substrate is achieved without causing back contamination. Japanese Patent Laying-Open No. 10-242107 discloses cleaning a substrate with a cleaning liquid partially saturated with an inert gas such as nitrogen. Japanese Patent Laying-Open No. 2009-214219 discloses that an appropriate degree of saturation of a gas dissolved in cleaning water used for cleaning is from 60% to 100%.

### Problems to Be Solved by the Invention

In the steps of manufacturing a substrate, particles of every size are removed from the substrate surface, in principle. Depending on the step, however, it is sometimes necessary to place importance on removing particles of a specific size. For example, in the final stage of the steps of manufacturing a substrate, an examination is conducted after particles of all sizes have been removed once, and in such an examination step, as well, particles may be attached to the substrate. The substrate is cleaned again, in order to remove such particles from the substrate. Since the particles attached to the substrate in the examination step as described above often have relatively large diameters, a cleaning method having high particle removal efficiency for particles with large diameters, in particular, is required for the cleaning after the examination step.

None of the above-described patent documents, however, discloses or suggests a cleaning method having improved particle removal efficiency of a specific size, with the size of the particles to be removed being focused.

This invention was made in order to solve the problem as described above. An object of the invention is to provide a cleaning method in which a foreign substance removal efficiency for particles of a specific size can be improved.

### Means for Solving the Problems

The inventors conducted extensive research concerning a relation between a dissolved nitrogen concentration in a cleaning liquid and a size of a foreign substance to be removed, in ultrasonic cleaning. Consequently, the inventors newly found that the dissolved nitrogen concentration showing the highest particle removal efficiency differs depending on the size of the foreign substance to be removed. Based on this finding, a cleaning method according to the present invention includes the steps of preparing a cleaning liquid, and cleaning an object to be cleaned by dipping the object in the cleaning liquid while irradiating the cleaning liquid with ultrasonic waves. In the cleaning step, the dissolved nitrogen concentration in the cleaning liquid has been adjusted in accordance with the size of a foreign substance that is to be removed from the object to be cleaned with the highest particle removal efficiency. In this way, the foreign substance of a specific size can be efficiently removed by changing the dissolved nitrogen concentration in the cleaning liquid in accordance with the size of the foreign substance to be removed.

In the above-described cleaning method, in the cleaning step, a particle size of the foreign substance that is to be removed from the object to be cleaned with the highest removal efficiency may be 0.12 µm or more, and a dissolved nitrogen concentration in the cleaning liquid may be not less than 3 ppm and not more than 5 ppm, or not less than 6 ppm and not more than 11 ppm.

Here, in a process of manufacturing a semiconductor device using a substrate, the presence of a large foreign substance having a particle size of 0.12 µm or more may become a critical hindrance to the process. For this reason, the dissolved nitrogen concentration in the cleaning liquid (dissolved nitrogen concentration) may be adjusted as described above to efficiently remove such a foreign substance of a large particle size from the substrate, thereby particularly effectively reducing the ratio of defective products in such a process.

In the above-described cleaning method, in the cleaning step, the object to be cleaned may be dipped in the cleaning liquid after variations in the dissolved nitrogen concentration in the cleaning liquid have become ±10 % or less, after starting the irradiation of the cleaning liquid with ultrasonic waves. In this case, cleaning is performed after the value of the dissolved nitrogen concentration in the cleaning liquid has become stable, thus allowing the foreign substance to be removed reliably.

In the above-described cleaning method, in the cleaning step, the object to be cleaned may be dipped in the cleaning liquid after 3 minutes or longer have elapsed since the irradiation of the cleaning liquid with ultrasonic waves started. In this case, the value of the dissolved nitrogen concentration in the cleaning liquid will become substantially stable after waiting for 3 minutes or longer from the start of the ultrasonic irradiation. Therefore, by performing cleaning after the dissolved nitrogen concentration has become stable as described above, it is possible to remove the foreign substance from the substrate reliably.

### Effects of the Invention

According to the present invention, a cleaning method in which a foreign substance removal efficiency of a specific size can be improved is achieved.

### Brief Description of the Drawings

Fig. 1 is a schematic diagram illustrating a structure of a cleaning apparatus that carries out a cleaning method according to the present invention.
Fig. 2 is a flowchart of the cleaning method according to the present invention.
Fig. 3 is a flowchart illustrating in detail the cleaning step shown in Fig. 2.
Fig. 4 is a graph illustrating experimental data.
Fig. 5 is a graph illustrating experimental data.
Fig. 6 is a graph illustrating experimental data.
Fig. 7 is a graph illustrating experimental data.
Fig. 8 is a graph illustrating experimental data.

### Description of the Reference Characters

1: ultrasonic cleaning apparatus
10: supply means
11: first supply valve
12: second supply valve
20: cleaning tank
21: coupling tank
22: holding portion
23: liquid introducing pipe
30: irradiation means
40: monitoring means
41: extraction pipe
42: pump
43: dissolved nitrogen concentration meter
44: measurement control unit
70: control device
71, 72, 73: wiring
W: wafer

### Modes for Carrying Out the Invention

Embodiments of the present invention will be described hereinafter, with reference to the drawings. In the drawings provided below, identical or corresponding parts are denoted by identical reference numbers, and description thereof will not be repeated.

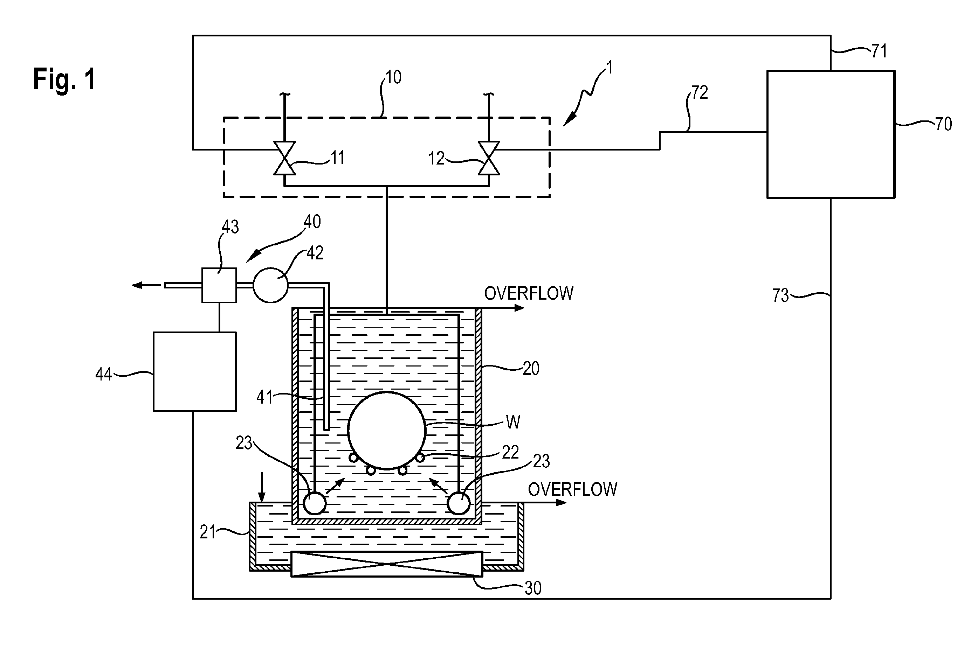

With reference to Figs. 1 to 3, a cleaning method according to the present invention and a cleaning apparatus that carries out the cleaning method will be described.

Here, an ultrasonic cleaning apparatus 1 that carries out the cleaning method according to the present invention includes, as shown in Fig. 1, a cleaning tank 20 for holding therein a cleaning liquid, such as ultrapure water, supply means 10 for supplying the cleaning liquid to cleaning tank 20, a coupling tank 21 for housing cleaning tank 20, irradiation means 30 for directing ultrasonic waves, installed at a bottom portion of coupling tank 21, monitoring means 40 for monitoring a dissolved nitrogen concentration in the cleaning liquid that has been supplied into cleaning tank 20, and a control device 70. Supply means 10 has a first supply valve 11 for supplying ultrapure water containing dissolved nitrogen therein to cleaning tank 20, and a second supply valve 12 for supplying degassed ultrapure water to cleaning tank 20.

First supply valve 11 is connected to a first tank, not illustrated. Ultrapure water containing dissolved nitrogen therein is stored in the first tank. Second supply valve 12 is connected to a device for producing degassed water, not illustrated. The ultrapure water is supplied to the device for producing degassed water, and the gas dissolved in the ultrapure water can be removed through a degassing membrane. The ultrapure water containing dissolved nitrogen therein and degassed ultrapure water are mixed when a pipe connected to first supply valve 11 and a pipe connected to second supply valve 12 are combined into a single pipe on a downstream side of first supply valve 11 and second supply valve 12. It is noted that a mixer tank (not illustrated) may be installed downstream of first supply valve 11 and second supply valve 12. In this case, ultrapure water containing dissolved nitrogen therein and degassed ultrapure water can be thoroughly mixed in the mixer tank.

The mixed ultrapure water is then supplied to a liquid introducing pipe 23 through the pipe connected to the downstream side of first supply valve 11 and second supply valve 12 described above and disposed within cleaning tank 20. Liquid introducing pipe 23 is disposed near an outer peripheral end of a bottom surface of cleaning tank 20. By adjusting the position of each of first supply valve 11 and second supply valve 12, the ultrapure water to be introduced into cleaning tank 20 can be controlled with respect to the dissolved nitrogen concentration therein and the amount of supply thereof. Each of first supply valve 11 and second supply valve 12 constituting supply means 10 of ultrasonic cleaning apparatus 1 is connected with control device 70 via wiring 71, 72, respectively. The position of first supply valve 11 and second supply valve 12 can be adjusted under signal control by control device 70.

A plurality of nozzles, not illustrated, is disposed on liquid introducing pipe 23. Ultrapure water serving as the cleaning liquid is supplied from liquid introducing pipe 23 via the nozzles into cleaning tank 20. The nozzles are disposed at intervals from one another along a direction in which liquid introducing pipe 23 extends. The nozzles are also installed so as to spray the cleaning liquid toward substantially the center (a region where a wafer W to be cleaned is being held) of cleaning tank 20.

In cleaning tank 20, a holding portion 22 for holding wafer W inside is disposed. A semiconductor wafer, for example, can be used as wafer W. With wafer W being held inside cleaning tank 20 by holding portion 22, the cleaning liquid composed of the above-described mixed ultrapure water is supplied into cleaning tank 20 from liquid introducing pipe 23.

As described above, liquid introducing pipe 23 is disposed on a lower portion of cleaning tank 20 (a region situated near a bottom wall or situated on an outer peripheral portion of the bottom wall, which is a portion connecting the bottom wall and side walls). A prescribed amount of the cleaning liquid (mixed ultrapure water) is supplied from liquid introducing pipe 23 into cleaning tank 20. Cleaning tank 20 is filled with the cleaning liquid, and the amount of the cleaning liquid supplied is adjusted such that a prescribed amount of the cleaning liquid overflows from the top of cleaning tank 20. In this way, wafer W is being dipped in the cleaning liquid inside cleaning tank 20, as shown in Fig. 1.

Coupling tank 21 is connected with a supply line (not illustrated) for a medium different from that of supply means 10 described above. Water serving as a medium is supplied from the supply line into coupling tank 21. At least the bottom wall of cleaning tank 20 described above is in contact with the water stored in coupling tank 21. A prescribed amount of water is continuously supplied from the supply line also to coupling tank 21, thereby causing a certain amount of water to be overflowing from coupling tank 21.

Irradiation means 30 is installed to be connected to a bottom wall of coupling tank 21. Irradiation means 30 directs ultrasonic waves to the water inside coupling tank 21. The cleaning liquid and wafer W inside cleaning tank 20 are irradiated with the directed ultrasonic waves via the water inside coupling tank 21 and a portion of cleaning tank 20 in contact with the water (for example, the bottom portion).

Irradiation means 30 can generate ultrasonic waves having a frequency not less than 20 kHz and not more than 2 MHz and a watt density not less than 0.05 W/cm² and not more than 7.0 W/cm², for example. By thus irradiating the cleaning liquid and wafer W with ultrasonic waves, wafer W dipped in the cleaning liquid can be efficiently cleaned. Preferably, ultrasonic waves having a frequency range not less than 400 kHz and not more than 1 MHz are used as the ultrasonic waves directed from irradiation means 30.

Monitoring means 40 includes an extraction pipe 41 for extracting a prescribed amount of the cleaning liquid from inside of cleaning tank 20, a pump 42 connected to extraction pipe 41 for introducing the cleaning liquid into a dissolved nitrogen concentration meter 43, and dissolved nitrogen concentration meter 43 connected to the downstream side of pump 42. Measured data of the dissolved nitrogen concentration in the cleaning liquid is outputted from dissolved nitrogen concentration meter 43 to control device 70 for ultrasonic cleaning apparatus 1 via a measurement control unit 44. Measurement control unit 44 is connected with control device 70 via wiring 73. Control device 70 is capable of adjusting the position of each of first supply valve 11 and second supply valve 12 based on the measured data.

A device having any structure can be used as dissolved nitrogen concentration meter 43. For example, a measurement device can be used that introduces a dissolved gas component contained in a cleaning liquid into a receptor through a polymer membrane, and calculates the concentration of the gas component based on a change in thermal conductivity within this receptor.

Cleaning tank 20 is made of, for example, quartz glass with a thickness of 3.0 mm. While cleaning tank 20 can have any shape, for example, a square tank whose internal dimensions are 280 mm in width, 350 mm in length, and 300 mm in height is used as cleaning tank 20. Cleaning tank 20 has a volume of approximately 30 liters.

The thickness of a plate material made of quartz glass constituting the bottom wall of cleaning tank 20 is preferably adjusted, as appropriate, in accordance with the frequency of the ultrasonic waves emitted from irradiation means 30. For example, where the frequency of ultrasonic waves emitted from irradiation means 30 is 950 kHz, the thickness of the plate material constituting the bottom wall is preferably 3.0 mm. Where the frequency of ultrasonic waves emitted from irradiation means 30 is 750 kHz, the thickness of the plate material constituting the bottom wall is preferably 4.0 mm, for example.

The amount of the cleaning liquid (mixed ultrapure water) supplied to cleaning tank 20 from supply means 10 may be 15 liters/minute. The frequency of ultrasonic waves directed from irradiation means 30 is 950 kHz or 750 kHz as mentioned above, and the output thereof is 2400 W (watt density: 5 W/cm²). A vibrating plate of irradiation means 30 has a radiation surface with a size of 210 mm × 230 mm. Ultrasonic waves emitted from irradiation means 30 are directed to the entire bottom surface of cleaning tank 20.

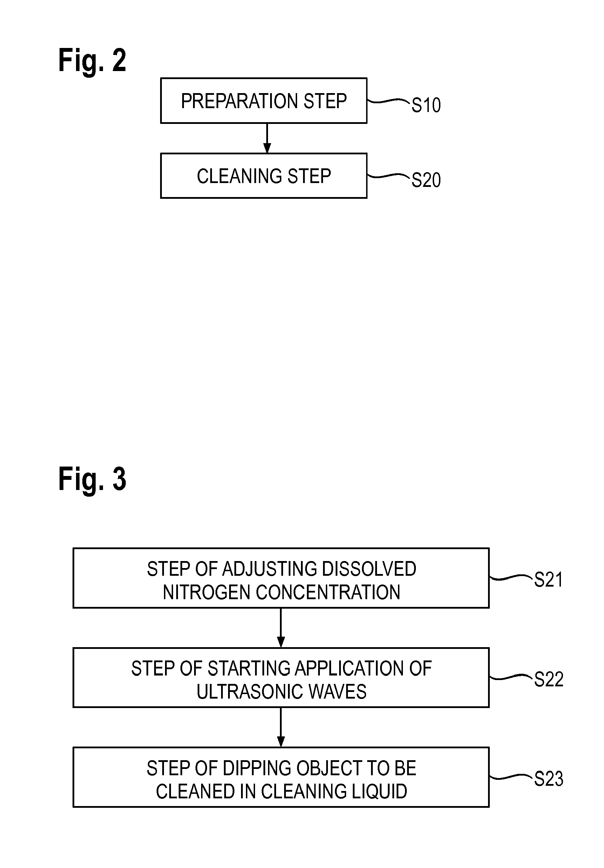

The cleaning method according to the present invention is carried out by using such ultrasonic cleaning apparatus 1. With reference to Fig. 2, in the cleaning method according to the present invention, a preparation step (S10) is carried out first. In this step (S10), ultrasonic cleaning apparatus 1 shown in Fig. 1 and a cleaning liquid (ultrapure water) to be supplied to ultrasonic cleaning apparatus 1 are prepared.

Next, a cleaning step (S20) shown in Fig. 2 is carried out. Specifically, a step of adjusting a dissolved nitrogen concentration (S21) shown in Fig. 3 is carried out first. In this step (S21), by adjusting the position of first supply valve 11 and second supply valve 12 constituting supply means 10, the cleaning liquid (ultrapure water) adjusted to a predetermined dissolved nitrogen concentration is supplied into cleaning tank 20.

Here, the dissolved nitrogen concentration in the cleaning liquid has been adjusted in the cleaning step (S20) in accordance with the size of a foreign substance to be removed from wafer W, which is an object to be cleaned, with the highest removal efficiency. For example, where the foreign substance (for example, particles) to be removed from wafer W with the highest removal efficiency has a particle size of 0.12 µm or more, the cleaning liquid is adjusted such that the dissolved nitrogen concentration in the cleaning liquid (dissolved nitrogen concentration) is not less than 3 ppm and not more than 5 ppm, or not less than 6 ppm and not more than 11 ppm. In this way, a foreign substance of a specific size can be efficiently removed by changing the dissolved nitrogen concentration in the cleaning liquid in accordance with the size of the foreign substance to be removed.

Next, a step of starting irradiation of ultrasonic waves (S22) shown in Fig. 3 is carried out. Specifically, ultrasonic waves satisfying predetermined conditions are generated from irradiation means 30. The ultrasonic waves are directed to the cleaning liquid inside cleaning tank 20 through the medium (water) held inside coupling tank 21 and the bottom wall of cleaning tank 20.

Next, a step of dipping the object to be cleaned in the cleaning liquid (S23) shown in Fig. 3 is carried out. Specifically, wafer W is dipped in the cleaning liquid inside cleaning tank 20. Wafer W is held by holding portion 22 inside cleaning tank 20.

Here, the above-described step (S23) is preferably carried out after variations in the dissolved nitrogen concentration in the cleaning liquid have become ±10 % or less, after the start of the irradiation of the cleaning liquid with ultrasonic waves. Further, stated from a different viewpoint, wafer W, which is the object to be cleaned, may be dipped in the cleaning liquid after 3 minutes or longer have elapsed since the irradiation of the cleaning liquid with ultrasonic waves started. This is because the value of the dissolved nitrogen concentration in the cleaning liquid irradiated with ultrasonic waves becomes stable, after a lapse of 3 minutes or longer from the start of the ultrasonic irradiation. In this case, cleaning is performed after the value of the dissolved nitrogen concentration in the cleaning liquid has become stable, thus allowing the foreign substance to be removed from wafer W reliably.

### First Experiment

The following experiment was conducted to examine a relation between a dissolved nitrogen concentration in a cleaning liquid and a size of a foreign substance to be removed.

### Sample:

A mirror wafer made of silicon with a diameter of 200 mm was prepared as an object to be cleaned. Silica particles were attached to the wafer surface.

### Experimental Method

The wafer having the silica particles attached to its surface was cleaned with a plurality of types of cleaning liquids having different dissolved nitrogen concentrations, by using the cleaning apparatus shown in Fig. 1, and the number and sizes of silica particles on the wafer surface before and after cleaning were measured. Specifically, the sizes and number of silica particles on the wafer surface before cleaning were measured, the wafer was cleaned, and the sizes and number of silica particles on the wafer surface after cleaning were measured.

The number and sizes of silica particles on the wafer surface were measured using a surface inspection system LS6500 manufactured by Hitachi High-Technologies Corporation or a surface inspection system SP1TBI manufactured by KLA-Tencor Corporation, under such conditions that the minimum detected particle size was 0.10 µm.

In the cleaning step, ultrapure water having predetermined dissolved nitrogen concentrations was obtained by mixing ultrapure water in which nitrogen gas was dissolved with degassed ultrapure water (degassed water) at various ratios, and the obtained water was used as the cleaning liquids. In the cleaning step, each cleaning liquid was supplied to the cleaning tank at a flow rate of 15 liters/minute. Since the cleaning tank had a volume of 30 liters, the rate of replacing the liquid inside the cleaning tank was approximately once per two minutes. The ultrasonic waves had a frequency of 750 kHz and a watt density of 5 W/cm². The cleaning time was set to 10 minutes per cleaning. Under such conditions, cleaning was performed with each of the cleaning liquids whose dissolved nitrogen concentration varied from 2.5 ppm to 16 ppm. The dissolved oxygen concentration at this time was less than 1 ppm.

### Results

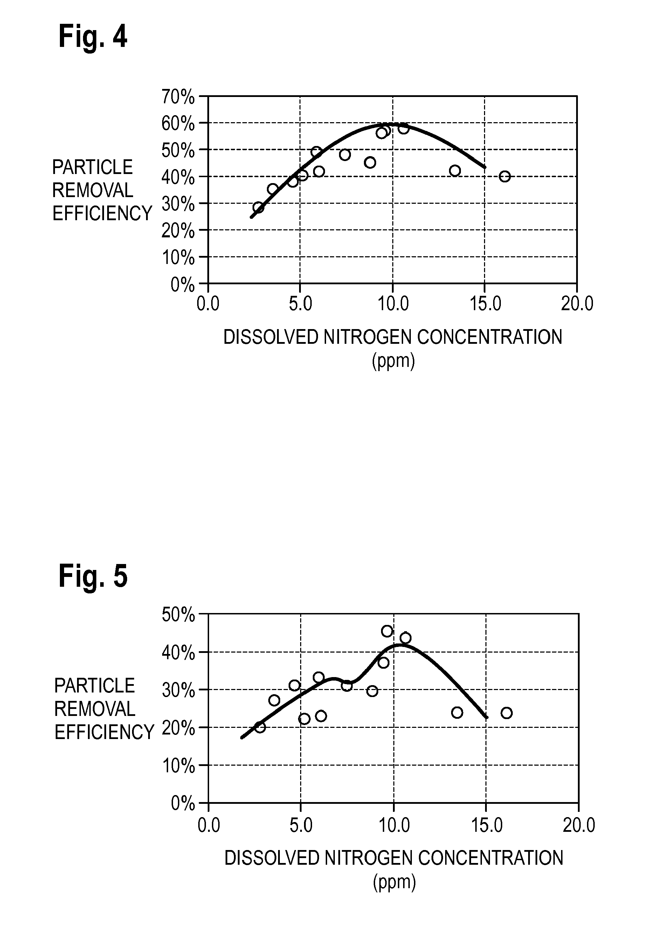

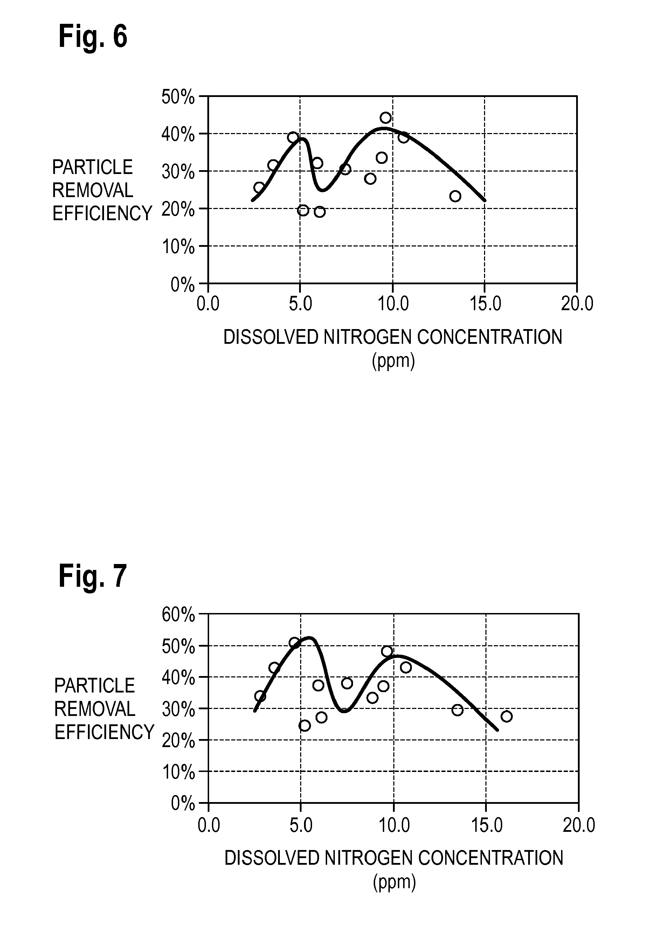

From the results of the measured sizes and the counted number of silica particles on the wafer surface before and after the cleaning, a particle removal efficiency was calculated for each size of silica particles. The particle removal efficiency was defined by the equation: (the number of silica particles before cleaning - the number of silica particles after cleaning)/(the number of silica particles before cleaning) x 100 (%), with respect to silica particles of a predetermined size. The sizes of silica particles were classified into the four sizes: a diameter of 0.10 µm or more, a diameter of 0.11 µm or more, a diameter of 0.12 µm or more, and a diameter of 0.13 µm or more. The results are shown in Figs. 4 to 7. Figs. 4 to 7 illustrate relations between the particle removal efficiency and the dissolved nitrogen concentration in the cleaning liquid, with respect to silica particles having a diameter of 0.10 µm or more, a diameter of 0.11 µm or more, a diameter of 0.12 µm or more, and a diameter of 0.13 µm or more, respectively. In each of Figs. 4 to 7, the horizontal axis represents the dissolved nitrogen concentration (unit: ppm) in the cleaning liquid, and the vertical axis represents the silica particles removal efficiency (unit: %). In the graph shown in each of Figs. 4 to 7, the white circles represent experimental data, and the solid line represents an approximate curve showing the tendency based on each set of the experimental data.

As shown in each of Figs. 4 to 7, the shape of the curve showing the dependence of the particle removal efficiency on the dissolved nitrogen concentration differs depending on the diameter (particle size) of the silica particles, which are particles to be removed. For example, where the silica particles have a size classified as a diameter of 0.10 µm or more, the particle removal efficiency shows a local maximum value when the dissolved nitrogen concentration has reached around 10 ppm, as shown in Fig. 4.

On the other hand, as the diameter of the silica particles to be considered is increased, the particle removal efficiency shows local maximum values when the dissolved nitrogen concentration is around 5 ppm and around 10 ppm. In this case, in a region where the dissolved nitrogen concentration is 5 to 6 ppm, the particle removal efficiency shows the local minimum value. From these results, where particles (foreign substance) of a relatively large particle size of 0.12 µm or more, for example, are intended to be efficiently removed, the dissolved nitrogen concentration in the cleaning liquid may be set to not less than 3 ppm and not more than 5 ppm, or not less than 6 ppm and not more than 11 ppm, thereby improving the particle removal efficiency with a relatively large particle size as described above.

### Second Experiment

The following experiment was conducted to examine a relation between an ultrasonic irradiation time in the cleaning step and a dissolved nitrogen concentration in the cleaning liquid.

### Sample

Ultrapure water having a dissolved nitrogen concentration of 7 ppm was prepared as a cleaning liquid to be introduced into the cleaning tank.

### Experimental Method

The cleaning apparatus shown in Fig. 1 was used, the above-described cleaning liquid was introduced into the cleaning tank of the cleaning apparatus, and thereafter the cleaning liquid was irradiated with ultrasonic waves. Then, transition of the dissolved nitrogen concentration in the cleaning liquid and transition of acoustic pressure after the start of ultrasonic irradiation were measured. The irradiated ultrasonic waves had a frequency of 950 kHz and an output of 2400 W.

The dissolved nitrogen concentration was measured using the dissolved nitrogen concentration meter of the cleaning apparatus. The acoustic pressure was measured by using a sound pressure meter ppb-502 and a sound pressure probe pb-308 manufactured by Alex Corporation, Japan. The probe was vertically set in a position 50 mm deep from the liquid surface of the cleaning tank, and the measurement was conducted in the standard mode recommended by the manufacturer.

### Results

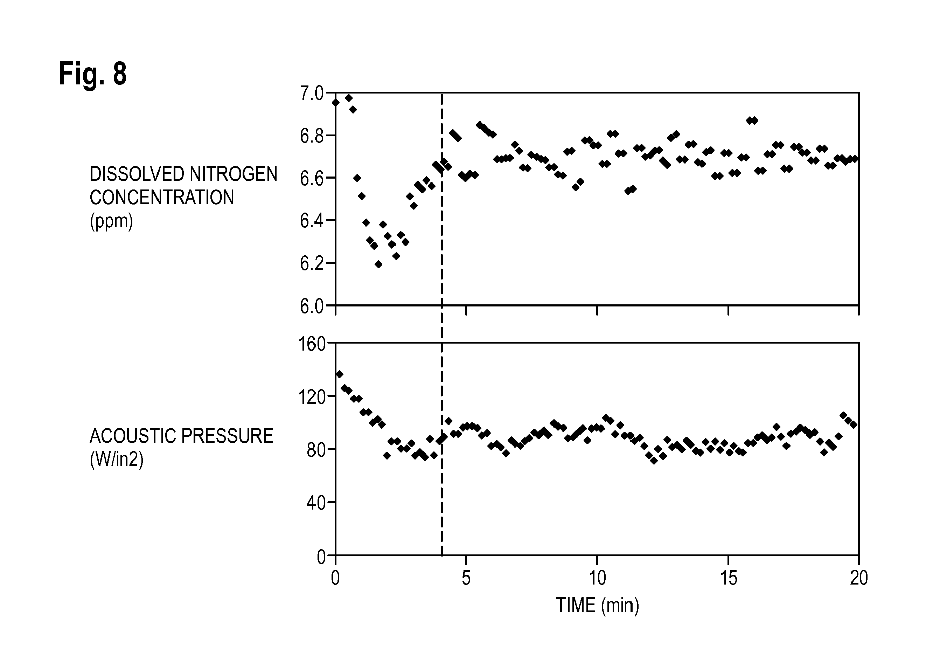

The measured results are shown in Fig. 8. The upper graph in Fig. 8 shows a relation between the dissolved nitrogen concentration and the time after the start of ultrasonic irradiation. The lower graph in Fig. 8 shows a relation between the acoustic pressure in the cleaning liquid and the time after the start of ultrasonic irradiation. The vertical axis of the upper graph in Fig. 8 represents dissolved nitrogen concentration (unit: ppm) in the cleaning liquid, and the horizontal axis represents the time (unit: minute) after the start of ultrasonic irradiation. The origin (0) of the horizontal axis represents the point of time at which the ultrasonic irradiation was started.

The vertical axis of the lower graph in Fig. 8 represents the acoustic pressure (unit: watt/square inch; W/in²; 1 in² = 6.4516 cm²), and the horizontal axis represents the time (unit: minute) after the start of ultrasonic irradiation, as in the upper graph in Fig. 8.

As can be seen from Fig. 8, after a lapse of 3 minutes or longer from the start of ultrasonic irradiation, the amount of variations in the dissolved nitrogen concentration in the cleaning liquid and the amount of variations in acoustic pressure become small (specifically, the variation is within ±10 % or less), and show stable values. That is, if the cleaning step is performed after the amount of variations in the dissolved nitrogen concentration in the cleaning liquid has become sufficiently small after waiting for a predetermined period of time (3 minutes, for example) from the start of ultrasonic irradiation, the occurrence of such problems as deviation of cleaning conditions from the settings caused by variations in the dissolved nitrogen concentration can be avoided. Therefore, a foreign substance (particles) can be removed from a wafer reliably.

It should be understood that the embodiments disclosed herein are illustrative and non-restrictive in every respect. The scope of the present invention is defined by the terms of the claims, rather than by the foregoing description, and is intended to include any modifications within the scope and meaning equivalent to the terms of the claims.

### Industrial Availability

This invention is particularly advantageously applied to the step of ultrasonic cleaning of a substrate.

## Claims

1. A cleaning method comprising the steps of:
preparing a cleaning liquid; and
cleaning an object to be cleaned by dipping said object to be cleaned in said cleaning liquid while irradiating said cleaning liquid with ultrasonic waves,
said cleaning step being **characterized by** a dissolved nitrogen concentration in said cleaning liquid having been adjusted in accordance with a size of a foreign substance that is to be removed from said object to be cleaned with highest removal efficiency.

2. The cleaning method according to claim 1, wherein in said cleaning step, a particle size of said foreign substance that is to be removed from said object to be cleaned with the highest removal efficiency is 0.12 µm or more, and a dissolved nitrogen concentration in said cleaning liquid is not less than 3 ppm and not more than 5 ppm, or not less than 6 ppm and not more than 11 ppm.

3. The cleaning method according to claim 1 or 2, wherein in said cleaning step, said object to be cleaned is dipped in said cleaning liquid after variations in the dissolved nitrogen concentration in said cleaning liquid have become ±10 % or less, after starting irradiation of said cleaning liquid with ultrasonic waves.

4. The cleaning method according to claim 3, wherein in said cleaning step, said object to be cleaned is dipped in said cleaning liquid after 3 minutes or longer have elapsed since the irradiation of said cleaning liquid with ultrasonic waves started.
